# EUROPÄISCHE PATENTSCHRIFT

(11) **EP 3 667 748 B1**
(45) Veröffentlichungstag und Bekanntmachung des Hinweises auf die Patenterteilung: **20.01.2021**
(21) Anmeldenummer: 19000512.4
(22) Anmeldetag: 08.11.2019
(51) Int. Cl.: H01L 43/06, H01L 43/14

(54) **HALBLEITERSENSORSTRUKTUR**
SEMICONDUCTOR SENSOR STRUCTURE
STRUCTURE DE CAPTEUR À SEMI-CONDUCTEUR

(30) Priorität: 22.11.2018 DE 102018009162
(43) Veröffentlichungstag der Anmeldung: 17.06.2020
(73) Patentinhaber: TDK-Micronas GmbH, 79108 Freiburg im Breisgau (DE)
(72) Erfinder: Cornils, Martin, 79100 Freiburg (DE); Vecchi, Maria-Cristina, 79104 Freiburg (DE)
(74) Vertreter: Koch Müller Patentanwaltsgesellschaft mbH

(56) Entgegenhaltungen:
- US-A1- 2017 271 399
- SANDER CHRISTIAN ET AL: "Isotropic 3D silicon hall sensor", 2015 28TH IEEE INTERNATIONAL CONFERENCE ON MICRO ELECTRO MECHANICAL SYSTEMS (MEMS), IEEE, 18. Januar 2015 (2015-01-18), Seiten 893-896, XP032740980, DOI: 10.1109/MEMSYS.2015.7051103 [gefunden am 2015-02-26]
- KYYNARAINEN ET AL: "A 3D micromechanical compass", SENSORS AND ACTUATORS A: PHYSICAL, ELSEVIER BV, NL, Bd. 142, Nr. 2, 26. Februar 2008 (2008-02-26), Seiten 561-568, XP022498844, ISSN: 0924-4247, DOI: 10.1016/J.SNA.2007.08.025

## Beschreibung

Die Erfindung betrifft eine Halbleitersensorstruktur und ein Halbleitersensorstrukturherstellungsverfahren, wobei die Halbleitersensorstruktur eine erste Halbleiterscheibe und eine zweite Halbleiterscheibe umfasst.

Aus der DE 10 2013 209 514 A1 ist ein dreidimensionaler Hallsensor zum Detektieren eines räumlichen Magnetfelds bekannt, wobei ein Halbleiterkörper mindestens drei Elektrodenpaaren aufweist, jedes Elektrodenpaar einen ersten Anschluss an einer Oberseite des Halbleiterkörpers und einen zweiten Anschluss an einer Unterseite des Halbleiterkörpers aufweist und mindestens drei Paare von Elektrodenpaaren mindestens drei Vierkontaktstrukturen bilden, welche die Messung jeweils einer räumlichen Komponente des Magnetfelds unter Nutzung des Halleffekts ermöglichen.

Aus "Isotropic 3D Silicon Hall Sensor", C. Sander et al., 28th IEEE Int. Conference on MEMS, 2015, 838-896 und "Monolithic Isotropie 3DSilicon Hall Sensor", C. Sander et al., Sensors and Actuators A, Col 247, 2016, 587-597 ist ein Aufbau umfassend eine 3D-Hallsensorstruktur auf einer Leiterplatte bekannt.

Aus "Handbook of 3D integration: technology and applicatins of 3D integrated ciruits", P. Garrou et al, Vol. 1, Weinheim: Wiley, 2008, S25-44 und S. 223-248, Kapiel 3 und 12, ISBN 978-527-32034-9 sind verschiedene Verfahren zum Stapeln von IC bekannt, wobei die ICs vollflächig verbunden und mittels Durchgangskontaktlöchern angeschlossen werden.

Aus "Challenges in Thin Wafer Handling and Processing", S. Olson et al., ASMC, 2013, 62-65 ist ein Verfahren zur Bereitstellung einer dünnen Halbleiterschicht mit prozessierter Vorder- und Rückseite bekannt.

Weitere Hallsensoranordnungen sind aus der US 2017 / 271 399 A1 und aus "Kyynarainen et al., A 3D micromechanical compass, Sensors and Actuators A: Physical Elsevier BV,NL Bd. 142, Nr. 2, 26 Februar 2008, Seiten 561 - 568, ISSN: 0924-4247" bekannt.

Vor diesem Hintergrund besteht die Aufgabe der Erfindung darin, eine Vorrichtung anzugeben, die den Stand der Technik weiterbildet.

Die Aufgabe wird durch eine Halbleitersensorstruktur mit den Merkmalen des Patentanspruchs 1 und ein Halbleitersensorstrukturherstellungsverfahren gemäß Anspruch 9 gelöst. Vorteilhafte Ausgestaltungen der Erfindung sind Gegenstand von Unteransprüchen.

Gemäß dem Gegenstand der Erfindung wird eine Halbleitersensorstruktur umfassend eine erste Halbleiterscheibe und eine zweite Halbleiterscheibe bereitgestellt, wobei die erste Halbleiterscheibe eine Halbleiterschicht von einem zweiten Leitfähigkeitstyp mit einer Vorderseite und einer Rückseite aufweist und die zweite Halbleiterscheibe eine an einer Rückseite ausgebildete Substratschicht und eine an einer Vorderseite ausgebildete integrierte Schaltung mit mindestens einem auf der Vorderseite ausgebildeten metallischen Anschlusskontakt aufweist.

In der Halbleiterschicht der ersten Halbleiterscheibe ist eine dreidimensionale Hallsensorstruktur mit einem Sensorgebiet ausgebildet, wobei das Sensorgebiet aus einem sich von der Rückseite zu der Vorderseite der Halbleiterschicht erstreckenden monolithischen Halbleiterkörper besteht.

Auf der Vorderseite sind wenigstens drei zueinander beabstandete erste metallische Anschlusskontakte und auf der Rückseite wenigstens drei zueinander beabstandete zweite metallische Anschlusskontakte ausgebildet.

In einer Projektion senkrecht zu der Vorderseite sind die ersten Anschlusskontakte gegenüber den zweiten Anschlusskontakten versetzt angeordnet und die ersten Anschlusskontakte und die zweiten Anschlusskontakte weisen jeweils bezüglich einer auf der Vorderseite und auf der Rückseite des Halbleiterkörpers senkrecht stehenden Symmetrieachse eine mehrzählige Rotationssymmetrie auf. Vorzugsweise handelt es sich um eine drelzählige Symmetrie.

Jeder erste Anschlusskontakt und jeder zweite Anschlusskontakt ist jeweils auf einem hochdotierten Halbleiterkontaktgebiet von einem zweiten Leitfähigkeitstyp ausgebildet.

Es versteht sich, dass die ersten Anschlusskontakte gegenüber den zweiten Anschlusskontakten deshalb versetzt angeordnet sind, da die zugehörigen hochdotierten Halbleiterkontaktgebiete der ersten Anschlusskontakte gegenüber den zugehörigen hochdotierten Halbleiterkontaktgebiete der zweiten Anschlusskontakte versetzt angeordnet sind.

Die Rückseite der ersten Halbleiterscheibe ist oberhalb der Vorderseite der zweiten Halbleiterscheibe angeordnet, wobei mindestens ein zweiter Anschlusskontakt der Hallsensorstruktur zumindest teilweise oberhalb eines metallischen Anschlusskontakts der integrierten Schaltung angeordnet ist.

Der metallische Anschlusskontakt der integrierten Schaltung ist mit dem oberhalb angeordneten zweiten Anschlusskontakt stoffschlüssig verbunden, so dass eine elektrische Wirkverbindung zwischen der Hallsensorstruktur und der integrierten Schaltung ausgebildet wird.

Es sei angemerkt, dass unter dem Ausdruck isotroper Hallsensor eine sogenannte 3D- oder drei-dimensionale Hallsensorstruktur verstanden wird, die in allen drei Raumrichtungen eine zusammenhängende Ausdehnung innerhalb des Halbleiterkörpers aufweist und wobei sich mittels der Hallsensorstruktur alle drei Komponenten eines Magnetfeldes bestimmen lassen.

Es versteht sich, dass die Ausbildung der hochdotierten Halbleiterkontaktgebiete vorzugsweise mittels eines Implantationsschritts erfolgt, wobei die Dosis oberhalb 10e15 N /cm³ liegt.

In der Halbleitersensorstruktur sind somit ein 3D-Hallsensor-Wafer und ein weiterer eine integrierte Schaltung umfassender Wafer, z.B. gemäß CMOS-Technologie, kombiniert wobei die beiden Wafer bzw. Halbleiterscheiben nur mittels der elektrischen Kontakte stoffschlüssig miteinander verbunden sind. Hierdurch lassen sich sehr empfindliche Hallsensoren kostengünstig und zuverlässig herstellen.

Wird der elektrische Kontakt zwischen den Anschlusskontakten der integrierten Schaltung und den zweiten Anschlusskontakten der Hallsensorstruktur mittels Kontaktierhügeln, sogenannten Bumps, wie sie aus der Flip-Chip-Montage bekannt sind, realisiert, so bildet sich bei geeigneter Höhe der Kontaktierhügel zwischen der Vorderseite der zweiten Halbleiterscheibe und der Rückseite der ersten Halbleiterscheibe inklusive der Isolationsschichten und außerhalb der Kontaktbereiche ein Luftspalt aus.

Bevorzugt sind die zweiten Anschlusskontakte der Hallsensorstruktur in einer Richtung parallel zu der Rückseite der Halbleiterschicht aus dem Sensorgebiet hinausgeführt und die stoffschlüssigen Kontakte zwischen den zweiten Anschlusskontakten der Hallsensorstruktur und den Anschlusskontakten der integrierten Schaltung sind in einer Projektion senkrecht zu der Rückseite der Halbleiterschicht außerhalb des Sensorgebiets angeordnet.

Die erfindungsgemäße Halbleitersensorstruktur stellt eine monolithische Ausführungsform eines isotropen Hallsensors dar, welche in CMOS-Technologie hergestellt werden kann. Durch die Integration mit der Schaltungstechnik wird das Bauelement besonders kompakt.

Gemäß einer ersten Weiterbildung ist der Halbleiterkörper mittels einer umlaufenden Grabenstruktur von der übrigen Halbleiterschicht elektrisch Isoliert ist.

Es versteht sich hierbei, dass die Grabenstruktur, die auch als Trench bezeichnet wird, von den ersten Anschlusskontakten und den zweiten Anschlusskontakten beabstandet angeordnet ist. Auch versteht es sich, dass der Halbleiterkörper bzw. die Sensorstruktur zwar von der übrigen Halbleiterschicht elektrisch isoliert ist, jedoch sind die ersten Anschlusskontakte und die zweiten Anschlusskontakte vorzugsweise mittels Leiterbahnen mit der integrierten Schaltung verbunden.

Vorzugsweise ist die Tiefe der Grabenstruktur derart ausgebildet, dass die Grabenstruktur die Halbleiterschicht durchtrennt. Anders ausgedrückt, die Tiefe der Grabenstruktur entspricht der Dicke der Halbleiterschicht. Vorzugsweise weist die Grabenstruktur an den Seitenwänden ganzflächig umlaufend eine SiO2 Schicht auf. Zwischen den Seltenwänden ist vorzugsweise ein dotiertes Polysilizium ausgebildet, wobei das Polysilizium zweckmäßigerweise mit einem Bezugspotential verschaltet ist.

In einer anderen Ausführungsform weist der Halbleiterkörper in dem Sensorgebiet eine Dicke von zwischen 2 µm und 50 µm auf. Höchst vorzugsweise weist der Halbleiterkörper in dem Sensorgebiet eine Dicke bis zu 100 µm auf. Vorzugsweise ist die Dicke des Halbleiterkörpers zumindest innerhalb des Sensorgebietes konstant. Insbesondere ist die Fläche an der Vorderseite des Halbleiterkörpers zu der Fläche an der Unterseite zumindest im Bereich des Sensorgebiets nahezu vollständig oder vollständig zueinander parallel und plan ausgebildet. Es sei angemerkt, dass unter nahezu vollständig ein Wert oberhalb von 90% verstanden wird.

Gemäß einer weiteren Ausführungsform umfasst in dem Sensorgebiet das Verhältnis von Dicke zu Länge des Halblelterkörpers einen Bereich zwischen 0,6 bis 1,4 oder einen Bereich zwischen 0,8 bis 1,2. Vorzugsweise liegt das Verhältnis bei 1,0.

Gemäß einer anderen Ausführungsform weist ein Durchmesser der ersten Halbleiterscheibe in einer Richtung parallel zu der Vorderseite zu einem Durchmesser der zweiten Halbleiterscheibe In derselben Richtung ein Verhältnis von 2:1 oder 3:1 auf.

In einer weiteren Weiterbildung umfassen die jeweils zweiten Anschlusskontakte der Hallsensorstruktur ein hoch dotiertes Polysilizium von einem zweiten Leitfähigkeitstyp.

Gemäß einer anderen Weiterbildung sind alle zweiten Anschlusskontakte der Hallsensorstruktur jeweils zumindest teilweise oberhalb eines metallischen Anschlusskontakts der integrierten Schaltung angeordnet und ist jeweils der metallische Anschlusskontakt der integrierten Schaltung mit dem oberhalb angeordneten zweiten Anschlusskontakt der Hallsensorstruktur stoffschlüssig verbunden, so dass eine elektrische Wirkverbindung zwischen der Hallsensorstruktur und der integrierten Schaltung ausgebildet wird.

In einer weiteren Ausführungsform umfassen die Anschlusskontakte der integrierten Schaltung Kontaktierhügel. Kontaktierhügel, die auch als Bumps bezeichnet werden und beispielsweise Gold enthalten, sind beispielsweise aus der Flip-Chip-Montage bekannt.

Gemäß einer weiteren Weiterbildung weist die Halbleiterschicht außerhalb der Hallsensorstruktur Gebiete von einem ersten Leitfähigkeitstyp auf.

In einer anderen Ausführungsform ist der erste Leitfähigkeitstyp p und der zweite Leitfähigkeitstyp n oder alternativ vice versa.

Gemäß weiterer Ausführungsformen weisen die zweiten Anschlusskontakte der Hallsensorstruktur und zumindest ein Teil der Anschlusskontakte der integrierten Schaltung jeweils einen Durchmesser von alternativ mindestens 10 µm oder mindestens 20 µm oder mindestens 80 µm oder mindestens 150 µm oder mindestens 400 µm auf.

Gemäß dem Gegenstand der Erfindung umfasst ein SOI-Halbleiterscheibenstrukturherstellungsverfahren mit einer ersten Halbleiterscheibe und einer zweiten Halbleiterscheibe der vorbeschriebenen Art zumindest folgende Prozessabschnittsbereiche :
In einem ersten Prozessabschnittsbereich wird auf einer ersten Halbleiterscheibe aufweisend eine Halbleiterschicht mit einer Vorderseite und einer Rückseite von einem zweiten Leitfähigkeitstyp in einer Vielzahl von Prozessschritten auf der Rückseite mittels Implantation wenigstens drei hochdotierte Halbleiterkontaktegebiete von dem zweiten Leitfähigkeitstyp hergestellt und auf jedem Halbeliterkontaktgebiet ein zweiter Anschlusskontakt angeordnet.

In einem zweiten Prozessabschnittsbereich wird auf einer zweiten Halbleiterscheibe aufweisend eine Substratschicht mit einer Rückseite und einer Vorderfläche in einer Vielzahl von Prozessschritten auf der Vorderseite eine integrierte Schaltung mit mindestens einem metallischen Anschlusskontakt auf der Vorderseite hergestellt. Vorzugsweise fungiert die zweite Halbleiterscheibe als ein Träger.

In einem dritten Prozessabschnittsbereich wird die erste Halbleiterscheibe mit der Rückseite oberhalb der Vorderseite der zweiten Halbleiterscheibe angeordnet und zumindest ein Anschlusskontakt der integrierten Schaltung mit einem der zweiten Anschlusskontakte stoffschlüssig verbunden, so dass bei dem Fügen die Vorderseite der ersten Halbleiterscheibe zu einer Oberseite der Halbleitersensorstruktur und die Rückseite der zweiten Halbleiterscheibe zu einer Rückseite der Halbleitersensorstruktur wird und die Rückseite der ersten Halbleiterscheibe nach dem Fügen zu einer vergrabenen unteren Fläche wird.

In einem vierten Prozessabschnittsbereich wird die Vorderseite der ersten Halbleiterscheibe gedünnt, nach dem Dünnen werden in einer Vielzahl von Prozessschritten auf der Vorderseite mittels Implantation wenigstens drei hochdotierte Halbleiterkontaktegebiete von dem zweiten Leitfähigkeitstyp hergestellt und auf jedem Kontaktgebiet wird ein erster Anschlusskontakt angeordnet, wobei in einer Projektion senkrecht zu der Vorderseite die ersten Anschlusskontakte bzw. die zugeordneten hochdotierten Halbleiterkontaktgebiete gegenüber den zweiten Anschlusskontakten versetzt sind und die ersten Anschlusskontakte und die zweiten Anschlusskontakte jeweils eine mehrzählige Rotationssymmetrie bezüglich einer auf der Vorderseite und auf der Rückseite des Halbleiterkörpers senkrecht sehenden Symmetrieachse aufweisen.

Es versteht sich, dass durch die Bezeichnungen "erster Prozessabschnittsbereich", "zweiter Prozessabschnittsbereich" usw. keine zeitliche Abfolge vorgegeben wird.

Gemäß einer ersten Ausführungsform wird der vierte Prozessabschnittsbereich vor dem dritten Prozessabschnittsbereich durchgeführt.

In einer anderen Ausführungsform wird in einem fünften Prozessabschnittsbereich auf der Vorderseite der Halbleiterschicht eine das Sensorgebiet vollständig umschließende Grabenstruktur ausgebildet.

Wie bereits ausgeführt versteht es sich hierbei, dass die Grabenstruktur von den ersten Anschlusskontakten und den zweiten Anschlusskontakten beabstandet angeordnet ist und die Sensorstruktur zwar von der übrigen Halbleiterschicht elektrisch isoliert Ist, jedoch sind die ersten Anschlusskontakte und die zweiten Anschlusskontakte vorzugsweise mittels Leiterbahnen mit der integrierten Schaltung verbunden.

Vorzugsweise ist die Tiefe der Grabenstruktur derart ausgebildet, dass die Grabenstruktur die Halbleiterschicht durchtrennt. Anders ausgedrückt, die Tiefe der Grabenstruktur entspricht der Dicke der Halbleiterschicht. Vorzugsweise weist die Grabenstruktur an den Seitenwänden ganzflächig umlaufend eine SiO2 Schicht auf. Zwischen den Seitenwänden ist vorzugsweise ein dotiertes Polysilizium ausgebildet, wobei das Polysilizium zweckmäßigerweise mit einem Bezugspotential verschaltet Ist.

Vorzugsweise ist der Halbleiterkörper bzw. das Sensorgebiet hexagonal ausgebildet. In einer Weiterbildung weist der Halbleiterkörper eine andere Form auf.

Gemäß einer weiteren Ausführungsform wird während des ersten Prozessabschnittsbereichs zum Anschluss der zweiten Kontaktgebiete ein dotiertes Polysilizium abgeschieden und strukturiert.

In einer Weiterbildung wird das strukturierte Polysilizium mittels eines Dielektrikums abgedeckt.

Gemäß einer weiteren Ausführungsform werden in einem sechsten Prozessabschnittsbereich außerhalb des Sensorgebiets liegende Teile der ersten Halbleiterscheibe abgetrennt.

In einer anderen Ausführungsform wird in dem vierten Prozessabschnittsbereich mittels eines CMP-Prozesses eine Halbleiterschicht mit einer Dicke zwischen 2 µm und 30 µm) ausgebildet wird. In einer Weiterbildung ist die Dicke der Halbleiterschicht zwischen 2 µm und 50 µm ausgebildet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine schematische Schnittansicht einer ersten erfindungsgemäßen Ausführungsform einer SOI-Halbleiterstruktur,
- Figur 2: eine schematische Aufsicht auf die erste erfindungsgemäße Ausführungsform der SOI-Halbleiterstruktur,
- Figur 3: eine schematische Ansicht einer ersten erfindungsgemäßen Ausführungsform des vierten Prozessabschnittsbereichs,
- Figur 4: eine schematische Ansicht einer ersten erfindungsgemäßen Ausführungsform des sechsten Prozessabschnittsbereichs.

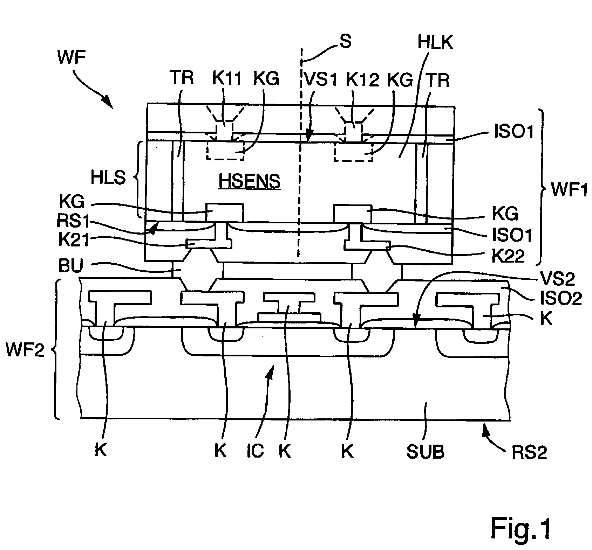

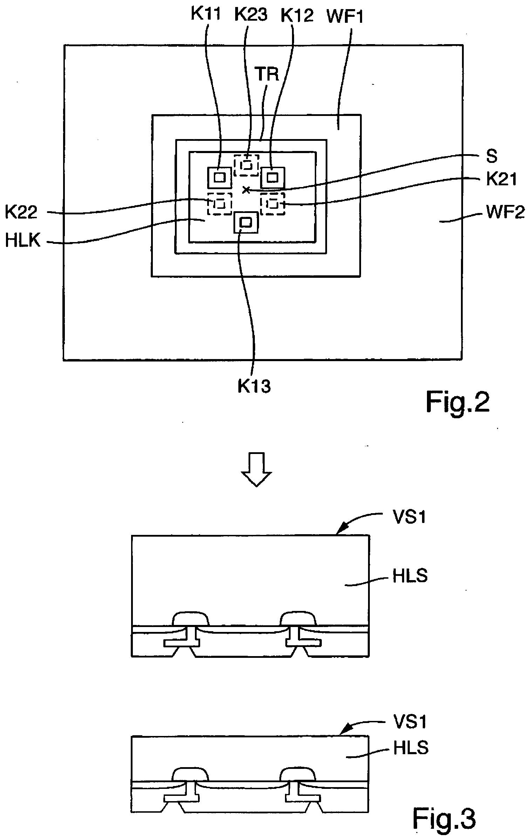

Die Abbildungen der Figuren 1 und 2 zeigen eine Schnittansicht bzw. eine Aufsicht einer ersten Ausführungsform einer erfindungsgemäßen Halbleitersensorstruktur WF aus einer ersten Halbleiterscheibe WF1 und einer zweiten Halbleiterscheibe WF2.

Die zweite Halbleiterscheibe WF2 weist eine an einer Rückseite RS2 ausgebildete Substratschicht SUB und eine an einer Vorderseite VS2 ausgebildete integrierten Schaltung IC, beispielsweise einen Transistor, mit mehreren auf der Vorderseite VS2 ausgebildeten metallischen Anschlusskontakten K auf. Die Rückseite RS2 der Substratschicht SUB bildet eine Rückseite der Halbleitersensorstruktur WF aus. Die Vorderseite VS2 und die Anschlusskontakte K sind von einer Isolationsschicht ISO2 bedeckt, wobei drei Anschlusskontakte K zumindest teilweise frei liegen.

Die erste Halbleiterscheibe WF1 ist oberhalb der Vorderseite VS2 der zweiten Halbleiterscheibe WF2 angeordnet und weist eine Halbleiterschicht HLS von einem zweiten Leitfähigkeitstyp mit einer Vorderseite VS1 und einer Rückseite RS1 auf. Die Rückseite RS1 der ersten Halbleiterscheibe und die Vorderseite VS2 der zweiten Halbleiterscheibe WF1 sind einander zugewandt und die Vorderseite VS1 der ersten Halbleiterscheibe WF1 bildet zumindest teilweise eine Vorderseite der Halbleitersensorstruktur aus.

In der Halbleiterschicht HLS ist eine drei dimensionale Hallsensorstruktur HSENS mit einem Sensorgebiet ausgebildet. Das Sensorgebiet besteht aus einem sich von der Rückseite RS1 zu der Vorderseite VS1 der Halbleiterschicht HLS erstreckenden monolithischen Halbleiterkörper HLK. Der Halbleiterkörper HLK ist mittels einer umlaufenden Grabenstruktur TR von der übrigen Halbleiterschicht HLS elektrisch isoliert.

Auf der Vorderseite VS1 der Halbleiterschicht HLS sind drei zueinander beabstandete erste metallische Anschlusskontakte K1.1, K1.2, K1.3 ausgebildet und auf der Rückseite RS1 sind drei zueinander beabstandete zweite metallische Anschlusskontakte K2.1, K2.2, K2.3 ausgebildet, wobei in einer Projektion senkrecht zu der Vorderseite VS die ersten Anschlusskontakte K1.1, K1.2, K1.3 gegenüber den zweiten Anschlusskontakten K2.1, K2.2, K2.3 versetzt sind. Außerdem weisen die ersten Anschlusskontakte K1.1, K1.2, K1.3 auf der Vorderseite VS1 und die zweiten Anschlusskontakte K2.1, K2.2, K2.3 auf der Rückseite RS jeweils eine dreizählige Rotationssymmetrie bezüglich einer auf der Vorderseite VS1 und auf der Rückseite RS1 des Halbleiterkörpers HLK senkrecht sehenden Symmetrieachse S auf.

Jeder erste Anschlusskontakt K1.1, K1.2, K1.3 und jeder zweite Anschlusskontakt K2.1, K2.2, K2.3 ist jeweils auf einem hochdotierten Halbleiterkontaktgebiet KG von einem zweiten Leitfähigkeitstyp ausgebildet. Es versteht sich, dass die den Anschlusskontakten zugeordneten hochdotierten Halbleiterkontaktgebiete gegeneinander verdreht angeordnet sind.

Die Vorderseite VS1 und die Rückseite RS1 sind jeweils von einer Isolationsschicht ISO1 bedeckt, wobei die Isolationsschichten ISO1 die ersten und zweiten Anschlusskontakte K1.1, K1.2, K1.3, K2.1, K2.2, K2.3 teilweise umschließen.

Die zweiten Anschlusskontakte K2.1, K2.2, K2.3 der Hallsensorstruktur HSENS sind jeweils zumindest teilweise oberhalb von metallischen Anschlusskontakten K der integrierten Schaltung IC angeordnet, wobei die metallischen Anschlusskontakte K der integrierten Schaltung IC mit den oberhalb angeordneten zweiten Anschlusskontakten K2.1, K2.2, K2.3 mittels eines Kontaktierhügels BU, z.B. aus Gold, stoffschlüssig verbunden sind, so dass eine elektrische Wirkverbindung zwischen der Hallsensorstruktur HSENS und der integrierten Schaltung IC ausgebildet wird.

Es sei angemerkt, dass nur aus Gründen der Übersichtlichkeit das Sensorgebiet bzw. der Halbleiterkörper HLK in der vorliegenden Darstellung eine quadratische Ausbildung aufweist. Vorzugsweise ist der Halbleiterkörper HLK bzw. das Sensorgebiet hexagonal ausgebildet. In einer Weiterbildung weist der Halbleiterkörper HLK eine andere Form auf.

In der Abbildung der Figur 3 ist eine erste erfindungsgemäße Ausführungsform eines vierten Prozessabschnittsbereichs dargestellt. Im Folgenden werden nur die Unterschiede zu der Abbildung der Figur 1 erläutert.

Nach dem Herstellen der hochdotierten Halbleiterkontaktgebiete KG auf der Rückseite RS1 der ersten Halbleiterscheibe WF1 und dem Anordnen der zweiten Anschlusskontakte K2.1, K2.2, K2.3 auf den Kontaktgebieten KG im Rahmen des ersten Prozessabschnittsbereichs wird in dem vierten Prozessabschnittsbereich die Halbleiterschicht HLS der ersten Halbleiterscheibe WF1 von der Vorderseite VS1 her gedünnt.

Anschließend (nicht mehr dargestellt) werden entsprechend dem ersten Prozessabschnittsbereich hochdotierte Kontaktgebiete KG auf der Vorderseite VS hergestellt und die ersten Anschlusskontakte K1.1, K1.2, K1.3 angeordnet.

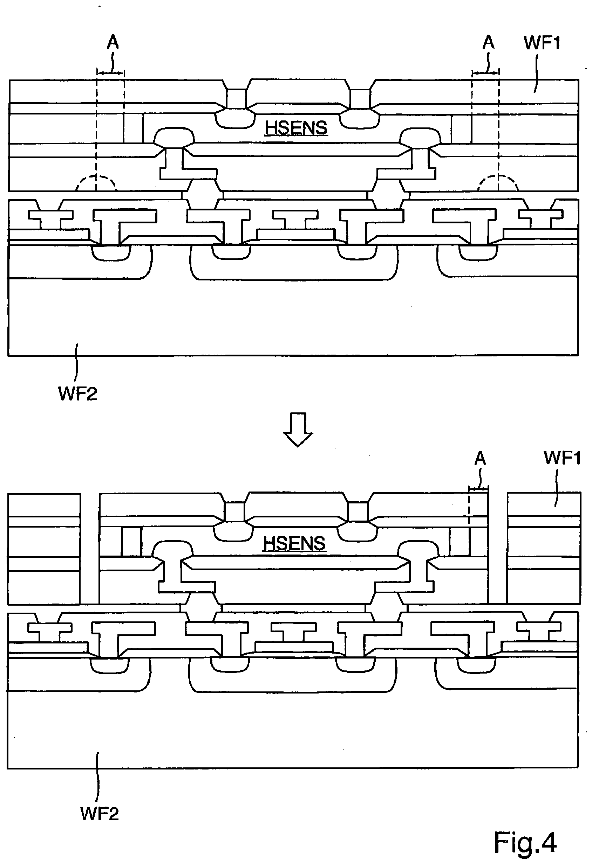

In der Abbildung der Figur 4 ist eine erste erfindungsgemäße Ausführungsform eines sechsten Prozessabschnittsbereichs dargestellt. Im Folgenden werden nur die Unterschiede zu der Abbildung der Figur 1 erläutert.

Ein außerhalb des durch die Grabenstruktur TR begrenzten Sensorgebiets befindlicher Teil der ersten Halbleiterscheibe WF1 wird in einem Abstand A zu der Grabenstruktur, beispielsweise durch Sägen, abgetrennt. Um während des gesamten Sägeprozesses einen ausreichenden Abstand zu der Vorderseite VS2 der zweiten Halbleiterscheibe sicherzustellen weist die Rückseite RS1 der erste Halbleiterscheibe WF1 innerhalb der Isolationsschicht ISO um den Abstand A zu der Grabenstruktur gemäß einer alternativen Ausführungsform einen Graben auf (gestrichelt dargestellt).

## Patentansprüche

1. Halbleitersensorstruktur (WF) umfassend eine erste Halbleiterscheibe (WF1), wobei
- die erste Halbleiterscheibe (WF1) eine Halbleiterschicht (HLS) von einem zweiten Leitfähigkeitstyp mit einer Vorderseite (VS1) und einer Rückseite (RS1) aufweist,
- in der ersten Halbleiterschicht (HLS) der ersten Halbleiterscheibe (WF1) eine dreidimensionale Hallsensorstruktur (HSENS) mit einem Sensorgebiet ausgebildet ist, wobei
- das Sensorgebiet aus einem sich von der Rückseite (RS1) zu der Vorderseite (VS1) der Halbleiterschicht (HLS) erstreckenden monolithischen Halbleiterkörper (HLK) besteht,
- auf der Vorderseite (VS1) wenigstens drei zueinander beabstandete erste metallische Anschlusskontakte (K1.1, K1.2, K1.3) und auf der Rückseite (RS1) wenigstens drei zueinander beabstandete zweite metallische Anschlusskontakte (K2.1, K2.2, K2.3) ausgebildet sind,
- in einer Projektion senkrecht zu der Vorderseite (VS) die ersten Anschlusskontakte (K1.1, K1.2, K1.3) gegenüber den zweiten Anschlusskontakten (K2.1, K2.2, K2.3) versetzt angeordnet sind,
- jeder erste Anschlusskontakt (K1.1, K1.2, K1.3) und jeder zweite Anschlusskontakt (K2.1, K2.2, K2.3) jeweils auf einem hochdotierten Halbleiterkontaktgebiet (KG) von einem zweiten Leitfähigkeitstyp ausgebildet ist,
- die ersten Anschlusskontakte (K1.1, K1.2, K1.3) und die zweiten Anschlusskontakte (K2.1, K2.2, K2.3) jeweils bezüglich einer auf der Vorderseite (VS1) und auf der Rückseite (RS1) des Halbleiterkörpers (HLK) senkrecht stehenden Symmetrieachse (S) mit einer mehrzähligen Rotationssymmetrie angeordnet sind,
**dadurch gekennzeichnet, dass**
- der Halbleiterkörper (HLK) mittels einer umlaufenden Grabenstruktur (TR) von der übrigen Halbleiterschicht (HLS) der ersten Halbleiterscheibe (WF1) elektrisch isoliert ist,
- der Halbleiterkörper (HLK) in dem Sensorgebiet eine Dicke von 2 µm bis 50 µm oder 100 µm aufweist,
- die Halbleitersensorstruktur (WF) eine zweite Halbleiterscheibe (WF2) umfasst, wobei
- die zweite Halbleiterscheibe (WF2) eine an einer Rückseite (RS) ausgebildete Substratschicht (SUB) und eine an einer Vorderseite (VS2) ausgebildete integrierte Schaltung (IC) mit mindestens einem auf der Vorderseite (VS2) ausgebildeten und einen Kontaktierhügel umfassenden metallischen Anschlusskontakt (K) aufweist,
- die Rückseite (RS1) der ersten Halbleiterscheibe (WF1) oberhalb der Vorderseite (VS2) der zweiten Halbleiterscheibe (WF2) angeordnet ist,
- mindestens ein zweiter Anschlusskontakt (K2.1, K2.2, K2.3) der Hallsensorstruktur (HSENS) zumindest teilweise oberhalb eines metallischen Anschlusskontakts (K) der integrierten Schaltung (IC) angeordnet ist und
- der metallische Anschlusskontakt (K) der integrierten Schaltung (IC) mittels des Kontakthügels mit dem oberhalb angeordneten zweiten Anschlusskontakt (K2.1, K2.2, K2.3) stoffschlüssig verbunden ist, so dass eine elektrische Wirkverbindung zwischen der Hallsensorstruktur (HSENS) und der integrierten Schaltung (IC) ausgebildet wird und
- der Kontakthügel eine geeignete Höhe aufweist, so dass sich zwischen der Rückseite der ersten Halbleiterscheibe (WF1) und der Vorderseite der zweiten Halbleiterscheibe (WF2) um die Kontakthügel ein Luftspalt ausbildet.

2. Halbleitersensorstruktur (WF) nach Anspruch 1, **dadurch gekennzeichnet, dass** der Halbleiterkörper (HLK) des Sensorgebiets ein Verhältnis von Dicke zu Länge zwischen 0,6 bis 1,4 oder zwischen 0,8 bis 1,2 aufweist.

3. Halbleitersensorstruktur (WF) nach einem der Ansprüche 1 oder 2, **dadurch gekennzeichnet, dass** ein Durchmesser der ersten Halbleiterscheibe (WF2) In einer Richtung parallel zu der Vorderseite (VS2) zu einem Durchmesser der zweiten Halbleiterscheibe (WF1) in derselben Richtung ein Verhältnis von 2:1 oder 3:1 aufweist.

4. Halbleitersensorstruktur (WF) nach einem der Ansprüche 1 bis 3, **dadurch gekennzeichnet, dass** die jeweils zweiten Anschlusskontakte (K2.1, K2.2, K2.3) der Hallsensorstruktur (HSENS) ein hochdotiertes Polysilizium von einem zweiten Leitfähigkeitstyp umfassen.

5. Halbleitersensorstruktur (WF) nach einem der Ansprüche 1 bis 4, dass alle zweiten Anschlusskontakt (K2.1, K2.2, K2.3) der Hallsensorstruktur (HSENS) jeweils zumindest teilweise oberhalb eines metallischen Anschlusskontakts (K) der integrierten Schaltung (IC) angeordnet sind und jeweils der metallische Anschlusskontakt (K) der integrierten Schaltung (IC) mit dem oberhalb angeordneten zweiten Anschlusskontakt (K2.1, K2.2, K2.3) der Hallsensorstruktur (HSENS) stoffschlüssig verbunden ist, so dass eine elektrische Wirkverbindung zwischen der Hallsensorstruktur (HSENS) und der integrierten Schaltung (IC) ausgebildet wird.

6. Halbleitersensorstruktur (WF) nach einem der Ansprüche 1 bis 5, **dadurch gekennzeichnet, dass** die Halbleiterschicht (HLS) außerhalb der Hallsensorstruktur Gebiete von einem ersten Leitfähigkeitstyp aufweist.

7. Halbleitersensorstruktur (WF) nach einem der Ansprüche 1 bis 6, **dadurch gekennzeichnet, dass** der erste Leitfähigkeitstyp p und der zweite Leitfähigkeitstyp n ist oder vice versa.

8. Halbleitersensorstruktur (WF) nach einem der Ansprüche 1 bis 7, **dadurch gekennzeichnet, dass** die zweiten Anschlusskontakte (K2.1, K2.2, K2.3) der Hallsensorstruktur (HSENS) und die Anschlusskontakte (K) der integrierten Schaltung (IC) jeweils einen Durchmesser von mindestens 10 µm oder mindestens 20 µm oder mindestens 80 µm aufweisen.

9. Halbleitersensorstrukturherstellungsverfahren zur Herstellung einer Halbleitersensorstruktur (WF) mit einer ersten Halbleiterscheibe (WF1) und einer zweiten Halbleiterscheibe (WF2) nach einem der Ansprüche 1 bis 8,
**wobei**
in einem ersten Prozessabschnittsbereich eine erste Halbleiterscheibe (WF1) aufweisend eine Halbleiterschicht (HLS) mit einer Vorderseite (VS1) und einer Rückseite (RS1) von einem zweiten Leitfähigkeitstyp in einer Vielzahl von Prozessschritten auf der Rückseite (RS1) mittels Implantation wenigstens drei hochdotierte Halbleiterkontaktegebiete (KG) von dem zweiten Leitfähigkeitstyp hergestellt werden und auf jedem Kontaktgebiet (KG) ein zweiter Anschlusskontakt (K2.1, K2.2, K2.3) angeordnet wird,
- in einem zweiten Prozessabschnittsbereich eine zweite Halbleiterscheibe (WF2) aufweisend eine Substratschicht (SUB) mit einer Rückseite (RS2) und einer Vorderfläche (VS2) in einer Vielzahl von Prozessschritten auf der Vorderseite (VS2) eine integrierte Schaltung (IC) mit mindestens einem einen Kontaktierhügel umfassenden metallischen Anschlusskontakt (K) auf der Vorderseite (VS2) hergestellt wird,
- in einem dritten Prozessabschnittsbereich die erste Halbleiterscheibe (WF1) mit der Rückseite (RS1) oberhalb der Vorderseite (VS2) der zweiten Halbleiterscheibe (WF2) angeordnet und zumindest ein Anschlusskontakt (K) der integrierten Schaltung (IC) mittels des Kontakthügels mit einem der zweiten Anschlusskontakte (K2.1, K2.2, K2.3) stoffschlüssig verbunden wird, so dass bei dem Fügen die Vorderseite (VS1) der ersten Halbleiterscheibe (WF1) zu einer Oberseite der Halbleitersensorstruktur (WF) und die Rückseite (RS2) der zweiten Halbleiterscheibe (WF2) zu einer Rückseite (RS) der Halbleitersensorstruktur (WF) wird, die Rückseite (RS1) der ersten Halbleiterscheibe (WF1) nach dem Fügen zu einer vergrabenen unteren Fläche wird und sich mittels einer geeigneten Höhe des Kontakthügels zwischen der Rückseite der ersten Halbleiterscheibe (WF1) und der Vorderseite der zweiten Halbleiterscheibe (WF2) um die Kontakthügel ein Luftspalt ausbildet,
- in einem vierten Prozessabschnittsbereich die Vorderseite (VS1) der ersten Halbleiterscheibe (WF1) gedünnt wird und nach dem Dünnen in einer Vielzahl von Prozessschritten auf der Vorderseite (VS1) mittels Implantation wenigstens drei hochdotierte Halbleiterkontaktegebiete (KG) von dem zweiten Leitfähigkeitstyp hergestellt werden und auf jedem Kontaktgebiet (KG) ein erster Anschlusskontakt (K1.1, K1.2, K1.3) angeordnet wird, wobei in einer Projektion senkrecht zu der Vorderseite (VS1) die ersten Anschlusskontakte (K1.1, K1.2, K1.3) gegenüber den zweiten Anschlusskontakten (K2.1, K2.2, K2.3) versetzt sind und die ersten Anschlusskontakte (K1.1, K1.2, K1.3) und die zweiten Anschlusskontakte (K2.1, K2.2, K2.3) jeweils mit einer mehrzähligen Rotationssymmetrie bezüglich einer auf der Vorderseite (VS1) und auf der Rückseite (RS1) des Halbleiterkörpers (HLK) senkrecht sehenden Symmetrieachse (S) zueinander angeordnet werden und
in einem fünften Prozessabschnittsbereich auf der Vorderseite (VS1) der Halbleiterschicht (HLS) eine das Sensorgebiet vollständig umschließende und von der übrigen Halbleiterschicht (HLS) elektrisch isolierende Grabenstruktur (TR) ausgebildet wird.

10. Halbleitersensorstrukturherstellungsverfahren nach Anspruch 9, **dadurch gekennzeichnet, dass** der vierte Prozessabschnittsbereich vor dem dritten Prozessabschnittsbereich durchgeführt wird.

11. Halbleltersensorstrukturherstellungsverfahren nach einem der Ansprüche 9 oder 10, **dadurch gekennzeichnet, dass** während des ersten Prozessabschnittsbereichs zum Anschluss der zweiten Kontaktgebiete (K2.1, K2.2, K2.3) ein dotiertes Polysilizium abgeschieden und strukturiert wird.

12. Halbleitersensorstrukturherstellungsverfahren nach Anspruch 11, **dadurch gekennzeichnet, dass** das strukturierte Polysilizium mittels eines Dielektrikums abgedeckt wird.

13. Halbleitersensorstrukturherstellungsverfahren nach einem der Ansprüche 9 bis 12, **dadurch gekennzeichnet, dass** in einem sechsten Prozessabschnittsbereich außerhalb des Sensorgebiets liegende Teile der ersten Halbleiterscheibe (WF1) abgetrennt werden.

14. Halbleitersensorstrukturherstellungsverfahren nach einem der Ansprüche 9 bis 13, **dadurch gekennzeichnet, dass** in dem vierten Prozessabschnittsbereich mittels eines CMP-Prozesses eine Halbleiterschicht (HLS) mit einer Dicke zwischen 2 µm und 30 µm ausgebildet wird.

## Claims

1. Semiconductor sensor structure (WF) comprising a first semiconductor wafer (WF1), wherein
- the first semiconductor wafer (WF1) comprises a semiconductor layer (HLS) of a second conductivity type with a front side (VS1) and a rear side (RS1),
- a three-dimensional Hall sensor structure (HSENS) with a sensor zone is formed in the first semiconductor layer (HLS) of the first semiconductor wafer (WF1). wherein
- the sensor zone consists of a monolithic semiconductor body (HLK) extending from the rear side (RS1) to the front side (VS1) of the semiconductor layer (HLS),
- at least three mutually spaced first metallic terminal contacts (K1.1, K.1.2, K1.3) are formed on the front side (VS1) and at least three mutually spaced second metallic terminal contacts (K2.1, K2.2, K2.3) are formed on the rear side (RS1),
- the first terminal contacts (K1.1, K1.2, K1.3) are arranged in a projection perpendicular to the front side (VS1) to be offset relative to the second terminal contacts (K2.1, K2.2, K2.3),
- each first terminal contact (K1.1, K1.2, K1.3) and each second terminal contact (K2.1, K2.2, K2.3) is formed on a respective highly doped semiconductor contact zone (KG) of a second conductivity type,
- the first terminal contacts (K1.1, K1.2, K1.3) and the second terminal contacts (K2.1, K2.2, K2.3) are respectively arranged with a multiple rotational symmetry with respect to an axis (S) of symmetry perpendicular to the front side (VS1) and to the rear side (RS1) of the semiconductor body (HLK),
**characterised in that**
- the semiconductor body (HLK) is electrically isolated by means of an encircling trench structure (TR) from the rest of the semiconductor layer (HLS) of the first semiconductor wafer (WF1),
- the semiconductor body (HLK) has a thickness of 2 microns up to 50 microns or 100 microns in the sensor zone,
- the semiconductor sensor structure (WF) comprises a second semiconductor wafer (WF2), wherein
- the second semiconductor wafer (WF2) comprises a substrate layer (SUB) formed at a rear side (RS2) and an integrated circuit (IC), which is formed at a front side (VS2), with at least one metallic terminal contact (K) formed on the front side (VS2) and comprising a contacting mound,
- the rear side (RS1) of the first semiconductor wafer (WF1) is arranged above the front side (VS2) of the second semiconductor wafer (WF2),
- at least one second terminal contact (K2.1, K2.2, K2.3) of the Hall sensor structure (HSENS) is arranged at least partly above a metallic terminal contact (K) of the integrated circuit (IC) and
- the metallic terminal contact (K) of the integrated circuit (IC) is connected by material couple and by means of the contact mound with the second terminal contact (K2.1, K2.2, K2.3) arranged above, so that an electrical operative connection is formed between the Hall sensor structure (HSENS) and the integrated circuit (IC) and
- the contact mound has a suitable height so that an air gap forms between the rear side of the second semiconductor wafer (WF1) and the front side of the second semiconductor wafer (WF2) around the contact mound.

2. Semiconductor sensor structure (WF) according to claim 1, **characterised in that** the semiconductor body (HLK) of the sensor zone has a ratio of thickness to length of between 0.6 to 1.4 or between 0.8 to 1.2.

3. Semiconductor sensor structure (WF) according to one of claims 1 and 2, **characterised in that** a diameter of the first semiconductor wafer (WF2) in a direction parallel to the front side (VS2) has a ratio of 2:1 or 3:1 to a diameter of the second semiconductor wafer (WF1) in the same direction.

4. Semiconductor sensor structure (WF) according to any one of claims 1 to 3, **characterised in that** the respective second terminal contacts (K2.1, K2.2, K2.3) of the Hall sensor structure (HSENS) comprise a highly doped polysilicon of a second conductivity type.

5. Semiconductor sensor structure (WF) according to any one of claims 1 to 4, **characterised in that** all second terminal contacts (K2.1, K2.2, K2.3) of the Hall sensor structure (HSENS) are respectively arranged at least partly above a metallic terminal contact (K) of the integrated circuit (IC) and in each instance the metallic terminal contact (K) of the integrated circuit (IC) is connected by material couple with the second terminal contact (K2.1, K2.2, K2.3), which is arranged above, of the Hall sensor structure (HSENS) so that an electrical operative connection is formed between the Hall sensor structure (HSENS) and the integrated circuit (IC).

6. Semiconductor sensor structure (WF) according to any one of claims 1 to 5, **characterised in that** the semiconductor layer (HLS) has zones of a first conductivity type outside the Hall sensor structure.

7. Semiconductor sensor structure (WF) according to any one of claims 1 to 6, **characterised in that** the first conductivity type is p and the second conductivity type is n or vice versa.

8. Semiconductor sensor structure (SF) according to any one of claims 1 to 7, **characterised in that** the second terminal contacts (K2.1, K2.2, K2.3) of the Hall sensor structure (HSENS) and the terminal contacts (K) of the integrated circuit (IC) each have a diameter of at least 10 microns or at least 20 microns or at least 80 microns.

9. Method of semiconductor sensor structure production for producing a semiconductor sensor structure (WF) with a first semiconductor wafer (WF1) and a second semiconductor wafer (WF2) according to any one of claims 1 to 8,
wherein
- in a first process section region at least three highly doped semiconductor contact zones (KG) of the second conductivity type are produced by means of implantation in a plurality of process steps at a first semiconductor wafer (WF1), which comprises a semiconductor layer (HLS) with a front side (VS1) and a rear side (RS1) of a second conductivity type, on the rear side (RS1) and a second terminal contact (K2.1. K2.2, K2.3) is arranged on each contact zone (KG),
- in a second process section region an integrated circuit (IC) with at least one metallic terminal contact (K), which comprises a contacting mound, is produced in a plurality of process steps at a second semiconductor wafer (WF2), which comprises a substrate layer (SUB) with a rear side (RS2) and a front surface (VS2), on the front side (VS2),
- in a third process section region the first semiconductor wafer (WF1) is arranged with the rear side (RS1) above the front side (VS2) of the second semiconductor wafer (WF2) and at least one terminal contact (K) of the integrated circuit (IC) is connected by material couple and by means of the contact mound with one of the second terminal contacts (K2.1, K2.2, K2.3) so that when joining takes place the front side (VS1) of the first semiconductor wafer (WF1) is towards an upper side of the semiconductor sensor structure (WF) and the rear side (RS2) of the second semiconductor wafer (WF2) is towards a rear side (RS) of the semiconductor sensor structure (WF), the rear side (RS1) of the first semiconductor wafer (WF1) after joining has taken place is towards a trenched lower surface and an air gap forms around the contact mound by means of a suitable height of the contact mound between the rear side of the first semiconductor wafer (WF1) and the front side of the second semiconductor wafer (WF2),
- in a fourth process section region the front side (VS1) of the first semiconductor wafer (WF1) is thinned and after the thinning at least three highly doped semiconductor contact zones (KG) of the second conductivity type are produced in a plurality of process steps on the front side (VS1) by means of implantation and a first terminal contact (K1.1, K1.2, K1.3) is arranged on each contact zone (KG), wherein the first terminal contacts (K1.1, K1.2, K1.3) are offset relative to the second terminal contacts (K2.1, K2.2, K2.3) in a projection perpendicular to the front side (VS1) and the first terminal contacts (K1.1, K1.2, K1.3) and the second terminal contacts (K2.1, K2.2, K2.3) are respectively arranged relative to one another with a multiple rotational symmetry with respect to an axis (S) of symmetry perpendicular to the front side (VS1) and the to rear side (RS1) of the semiconductor body (HLK) and
- in a fifth process section region a trench structure (TR) completely surrounding the sensor zone and electrically isolated from the rest of the semiconductor layer (HLS) is formed on the front side (VS1) of the semiconductor layer (HLS).

10. Method of semiconductor sensor structure production according to claim 9, **characterised in that** the fourth process section region is carried out before the third process section region.

11. Method of semiconductor sensor structure production according to one of claims 9 and 10, **characterised in that** during the first process section region a doped polysilicon is precipitated and structured for connection of the second contact zones (K2.1, K2.2, K2.3).

12. Method of semiconductor sensor structure production according to claim 11, **characterised in that** the structed polysilicon is covered by means of a dielectric.

13. Method of semiconductor sensor structure production according to any one of claims 9 to 12, **characterised in that** in a sixth process section region parts, which lie outside the sensor zone, of the first semiconductor wafer (WF1) are separated off.

14. Method of semiconductor sensor structure production according to any one of claims 9 to 13, **characterised in that** in the fourth process section region a semiconductor layer (HLS) with a thickness between 2 microns and 30 microns is formed by means of a CMP process.

## Revendications

1. Structure de capteur à semi-conducteur (WF) comprenant une première tranche de semi-conducteur (WF1), dans laquelle
- la première tranche de semi-conducteur (WF1) comprend une couche semi-conductrice (HLS) présentant un second type de conductivité qui présente une face avant (VS1) et une face arrière (RS1),
- une structure de capteur à effet Hall tridimensionnelle (HSENS) comportant une zone de détection est formée dans la première couche semi-conductrice (HLS) de la première tranche de semi-conducteur (WF1), dans laquelle :
- la zone de détection est constituée d'un corps semi-conducteur monolithique (HLK) qui s'étend à partir de la face arrière (RS1) jusqu' à la face avant (VS1) de la couche semi-conductrice (HLS),
- au moins trois premiers contacts de connexion métalliques (K1.1, K1.2, K1.3) sont formés à distance les uns des autres sur la face avant (VS1) et au moins trois seconds contacts de connexion métalliques (K2.1, K2.2, K2.3) sont formés à distance les uns des autres sur la face arrière (RS1),
- les premiers contacts de connexion (K1.1, K1.2, K1.3) sont décalés par rapport aux seconds contacts de connexion (K2.1, K2.2, K2.3) dans une projection perpendiculaire à la face avant (VS),
- chaque premier contact de connexion (K1.1, K1.2, K1.3) et chaque second contact de connexion (K2.1, K2.2, K2.3) est formé respectivement sur une zone de contact semi-conductrice fortement dopée (KG) qui présente un second type de conductivité,
- les premiers contacts de connexion (K1.1, K1.2, K1.3) et les seconds contacts de connexion (K2.1, K2.2, K2.3) sont disposés respectivement avec une symétrie de rotation multiple par rapport à un axe de symétrie (S) qui est perpendiculaire à la face avant (VS1) et à la face arrière (RS1) du corps semi-conducteur (HLK), **caractérisé en ce que**
- le corps semi-conducteur (HLK) est isolé électriquement du reste de la couche semi-conductrice (HLS) de la première tranche de semi-conducteur (WF1) par l'intermédiaire d'une structure en tranchage périphérique (TR),
- le corps semi-conducteur (HLK) présente une épaisseur qui est comprise entre 2 µm et 50 µm ou qui est égale à 100 µm dans la zone de détection,
- la structure de capteur à semi-conducteur (WF) comprend une seconde tranche de semi-conducteur (WF2), dans laquelle
- la seconde tranche de semi-conducteur (WF2) comprend une couche de substrat (SUB) qui est formée sur une face arrière (RS) et un circuit intégré (IC) qui est formé sur une face avant (VS2), ledit circuit intégré comprenant au moins un contact de connexion métallique (K) qui est formé sur la face avant (VS2) et qui comporte une bosse de contact,
- la face arrière (RS1) de la première tranche de semi-conducteur (WF1) est disposée au-dessus de la face avant (VS2) de la seconde tranche de semi-conducteur (WF2),
- au moins un second contact de connexion (K2.1, K2.2, K2.3) de la structure de capteur à effet Hall (HSENS) est disposé au moins en partie au-dessus d'un contact de connexion métallique (K) du circuit intégré (IC), et
- le contact de connexion métallique (K) du circuit intégré (IC) est relié par liaison de matière, par l'intermédiaire de la bosse de contact, au second contact de connexion (K2.1, K2.2, K2.3) qui est disposé au-dessus de celui-ci, de telle sorte qu'une liaison électrique active soit établie entre la structure de capteur à effet Hall (HSENS) et le circuit intégré (IC), et
- la bosse de contact présente une hauteur appropriée, de telle sorte qu'un entrefer se forme autour des bosses de contact entre la face arrière de la première tranche de semi-conducteur (WF1) et la face avant de la seconde tranche de semi-conducteur (WF2).

2. Structure de capteur à semi-conducteur (WF) selon la revendication 1, **caractérisée en ce que** le corps semi-conducteur (HLK) de la zone de détection présente un rapport de l'épaisseur à la longueur qui est compris entre 0,6 et 1,4 ou entre 0,8 et 1,2.

3. Structure de capteur à semi-conducteur (WF) selon l'une quelconque des revendications 1 ou 2, **caractérisée en ce qu'**un diamètre de la première tranche de semi-conducteur (WF2) présente un rapport de 2:1 ou de 3:1 dans une direction parallèle à la face avant (VS2) par rapport à un diamètre de la seconde tranche de semi-conducteur (WF1) dans la même direction.

4. Structure de capteur à semi-conducteur (WF) selon l'une quelconque des revendications 1 à 3, **caractérisée en ce que** les seconds contacts de connexion (K2.1, K2.2, K2.3) respectifs de la structure de capteur à effet hall (HSENS) comprennent un polysilicium fortement dopé qui présente un second type de conductivité.

5. Structure de capteur à semi-conducteur (WF) selon l'une quelconque des revendications 1 à 4, **caractérisée en ce que** la totalité des seconds contacts de connexion (K2.1, K2.2, K2.3) de la structure de capteur à effet Hall (HSENS) sont disposés respectivement au moins en partie au-dessus d'un contact de connexion métallique (K) du circuit intégré (IC), et chaque contact de connexion métallique (K) du circuit intégré (IC) est relié par liaison de matière au second contact de connexion (K2.1, K2.2, K2.3) qui est disposé au-dessus de la structure de capteur à effet Hall (HSENS), de telle sorte qu'une liaison électrique active soit établie entre la structure de capteur à effet Hall (HSENS) et le circuit intégré (IC).

6. Structure de capteur à semi-conducteur (WF) selon l'une quelconque des revendications 1 à 5, **caractérisée en ce que** la couche semi-conductrice (HLS) comprend des zones présentant un premier type de conductivité qui sont situées en dehors de la structure du capteur à effet Hall.

7. Structure de capteur à semi-conducteur (WF) selon l'une quelconque des revendications 1 à 6, **caractérisée en ce que** le premier type de conductivité est p et le second type de conductivité est n, ou vice versa.

8. Structure de capteur à semi-conducteur (WF) selon l'une quelconque des revendications 1 à 7, **caractérisée en ce que** les seconds contacts de connexion (K2.1, K2.2, K2.3) de la structure de capteur à effet Hall (HSENS) et les contacts de connexion (K) du circuit intégré (IC) présentent respectivement un diamètre qui est égal à au moins 10 µm, ou à au moins 20 µm ou à au moins 80 µm.

9. Procédé de production d'une structure de capteur à semi-conducteur qui permet de produire une structure de capteur à semi-conducteur (WF) comprenant une première tranche de semi-conducteur (WF1) et une seconde tranche de semi-conducteur (WF2) selon l'une quelconque des revendications 1 à 8, dans lequel
- dans une première partie du processus, une première tranche de semi-conducteur (WF1) comprend une couche semi-conductrice (HLS) qui présente une face avant (VS1) et une face arrière (RS1) présentant un second type de conductivité, au moins trois zones de contact semi-conductrices fortement dopées (KG) qui présentent le second type de conductivité sont produites en une pluralité d'étapes de processus sur la face arrière (RS1) par implantation, et un second contact de connexion (K2.1, K2.2, K2.3) est disposé sur chaque zone de contact (KG),
- dans une deuxième partie du processus, une seconde tranche de semi-conducteur (WF2) comprend une couche de substrat (SUB) qui présente une face arrière (RS2) et une face avant (VS2), un circuit intégré (IC) comprenant au moins un contact de connexion métallique (K) qui comporte une bosse de contact est produit sur la face avant (VS2) en une pluralité d'étapes de processus sur la face avant (VS2),
- dans une troisième partie du processus, la première tranche de semi-conducteur (WF1) est disposée avec sa face arrière (RS1) qui est située au-dessus de la face avant (VS2) de la seconde tranche de semi-conducteur (WF2) et au moins un contact de connexion (K) du circuit intégré (IC) est relié par liaison de matière à l'un des seconds contacts de connexion (K2.1, K2.2, K2.3) par l'intermédiaire de la bosse de contact, de telle sorte que, lors de l'assemblage, la face avant (VS1) de la première tranche de semi-conducteur (WF1) devienne une face supérieure de la structure de capteur à semi-conducteur (WF) et que la face arrière (RS2) de la seconde tranche de semi-conducteur (WF2) devienne une face arrière (RS) de la structure de capteur à semi-conducteur (WF), la face arrière (RS1) de la première tranche de semi-conducteur (WF1) devenant, après l'assemblage, une surface inférieure enfouie et un entrefer se formant autour de la bosse de contact, par l'entremise d'une hauteur appropriée de la bosse de contact, entre la face arrière de la première tranche de semi-conducteur (WF1) et la face avant de la seconde tranche de semi-conducteur (WF2),
- dans une quatrième partie du processus, la face avant (VS1) de la première tranche de semi-conducteur (WF1) est amincie et, après amincissement, au moins trois zones de contact semi-conductrices (KG) fortement dopées qui présentent le second type de conductivité sont produites en une pluralité d'étapes de processus sur la face avant (VS1) par implantation, et un premier contact de connexion (K1.1, K1.2, K1. 3) est disposé sur chaque zone de contact (KG), les premiers contacts de connexion (K1.1, K1.2, K1.3) étant décalés par rapport aux seconds contacts de connexion (K2.1, K2.2, K2.3) dans une projection perpendiculaire à la face avant (VS1), et les premiers contacts de connexion (K1.1, K1.2, K1.3) et les seconds contacts de connexion (K2.1, K2.2, K2.3) étant disposés les uns par rapport aux autres respectivement avec une symétrie de rotation multiple par rapport à un axe de symétrie (S) qui est perpendiculaire à la face avant (VS1) et à la face arrière (RS1) du corps semi-conducteur (HLK), et
- dans une cinquième partie du processus, une structure en tranchée (TR) qui entoure complètement la zone de détection et qui est électriquement isolante par rapport au reste de la couche semi-conductrice (HLS) est formée sur la face avant (VS1) de la couche semi-conductrice (HLS).

10. Procédé de production d'une structure de capteur à semi-conducteur selon la revendication 9, **caractérisé en ce que** la quatrième partie du processus est réalisée avant la troisième partie du processus.

11. Procédé de production d'une structure de capteur à semi-conducteur selon l'une quelconque des revendications 9 ou 10, **caractérisé en ce qu'**un polysilicium dopé est déposé et structuré au cours de la réalisation de la première partie du processus dans le but de permettre la connexion des secondes zones de contact (K2.1, K2.2, K2.3).

12. Procédé de production d'une structure de capteur à semi-conducteur selon la revendication 11, **caractérisé en ce que** le polysilicium structuré est recouvert en utilisant un diélectrique.

13. Procédé de production d'une structure de capteur à semi-conducteur selon l'une quelconque des revendications 9 à 12, **caractérisé en ce que** des parties de la première tranche de semi-conducteur (WF1) qui sont situées en dehors de la zone de détection sont séparées au cours d'une sixième partie du processus.

14. Procédé de production d'une structure de capteur à semi-conducteur selon l'une quelconque des revendications 9 à 13, **caractérisé en ce qu'**une couche semi-conductrice (HLS) d'une épaisseur comprise entre 2 µm et 30 µm est formée dans la quatrième partie du processus en exécutant un traitement de polissage par CMP.
